# DEMANDE DE BREVET EUROPEEN

(11) **EP 4 577 000 A1**
(43) Date de publication de la demande: **25.06.2025**
(21) Numéro de dépôt: 24221543.2
(22) Date de dépôt: 19.12.2024
(51) Int. Cl.: H10F 19/80, H10F 19/90

(54) **MODULE PHOTOVOLTAÏQUE COMPORTANT UNE STRUCTURE D'ENCAPSULATION À BASE D'AU MOINS UN MATÉRIAU POLYMÈRE ET LOCALEMENT ASSOUPLIE**

(30) Priorité: 20.12.2023 FR 2314604
(71) Demandeur: Commissariat à l'Energie Atomique et aux Energies Alternatives, 75015 Paris (FR)
(72) Inventeur: HABANS, Dylan, 38054 Grenoble cedex 9 (FR); CHARPENTIER, Jean-Baptiste, 38054 Grenoble cedex 9 (FR); DERRIER, Aude, 38054 Grenoble cedex 9 (FR)
(74) Mandataire: Ipsilon NNY

(57) **Abrégé**

Module photovoltaïque (1) comportant :
- une unité photovoltaïque (6) comportant plusieurs cellules photovoltaïques (3) reliées électriquement en série et distantes les unes des autres, les cellules photovoltaïques adjacentes étant reliées électriquement deux à deux par un interconnecteur métallique (4) qui s'étend au moins en partie dans un espace d'interconnexion (2) séparant lesdites cellules photovoltaïques adjacentes,
- une structure d'encapsulation (8) en un matériau d'encapsulation à base polymère prenant en sandwich les faces opposées des cellules photovoltaïques, définissant une zone de recouvrement cellulaire (10), et l'interconnecteur dans l'espace d'interconnexion, définissant une zone de recouvrement d'interconnecteur (11),
une cale (12) incorporée dans la structure d'encapsulation et partiellement superposée à l'interconnecteur dans la zone de recouvrement d'interconnecteur, la cale étant constitué par matériau présentant, au moins à une température de -40 °C, un module d'élasticité inférieur au module d'élasticité du matériau d'encapsulation.

## Description

### Domaine technique

La présente invention concerne la résistance au cyclage thermique de modules photovoltaïques comportant des cellules photovoltaïques intégrées dans une structure d'encapsulation à base d'au moins un matériau polymère.

### Technique antérieure

L'intégration de modules photovoltaïques dans les bâtiments, infrastructures ou dans les véhicules est un moyen pour augmenter simplement la surface de captation du rayonnement solaire pour la production énergétique de masse.

Cependant, cette démarche d'intégration nécessite une adaptation de la forme et de l'esthétique des modules photovoltaïques, ainsi qu'une réduction de leur masse, tout en garantissant un niveau de performance et de durabilité conforme à la réglementation et en s'inscrivant dans une démarche de réduction de l'empreinte environnementale afin d'atteindre l'objectif de zéro carbone net à l'horizon 2035.

Les matériaux polymères thermoplastiques présentent un faible coût, de bonnes propriétés mécaniques, une faible masse volumique et une bonne recyclabilité, qui en font de bons candidats pour la fabrication de modules photovoltaïques légers. Ils peuvent ainsi être utilisés pour recouvrir les cellules photovoltaïques et les maintenir ensemble dans une structure rigide.

Cependant, ces matériaux sont des polymères. En tant que tel, ils présentent une forte aptitude à se déformer sous l'effet de la température, caractérisée par un coefficient d'expansion thermique (CTE) élevé. Chaque polymère présente un CTE qui lui est propre et qui dépend de sa composition et de son procédé d'élaboration. Notamment, le CTE de nombreux polymères est environ dix fois plus grand que le CTE de nombreux métaux et jusqu'à cent fois supérieur au CTE du silicium.

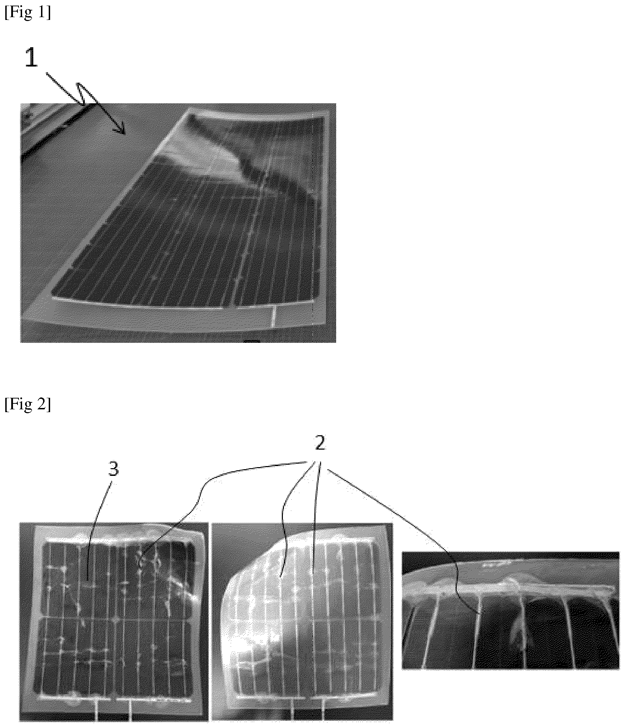

La figure 1 illustre un premier exemple de dégradation d'un tel type de module photovoltaïque 1, dénommé effet de galbe, suite à la mise en oeuvre d'une fabrication par lamination. L'effet de galbe est un défaut de planéité du module photovoltaïque qui se développe lors du refroidissement du module photovoltaïque suite à la lamination. Il est généralement causé par une différence de coefficient de dilatation thermique entre la face avant et la face arrière du module photovoltaïque.

La figure 2 illustre plusieurs exemples de dégradations de ces modules photovoltaïques, apparaissant après cyclage thermique, qui sont observées au niveau des zones 2 où les interconnecteurs électriques recouvrent les cellules photovoltaïques 3. Sous l'effet de fortes contraintes thermiques, une délamination apparaît entre les cellules photovoltaïques et/ou les interconnecteurs et l'encapsulant polymère. Les matériaux polymères sont également déchirés, ce qui témoigne du niveau de contrainte élevé atteint dans ces zones.

La différence entre d'une part le CTE du silicium, constitutif des cellules photovoltaïques 4, ou le CTE des métaux tel que le cuivre, utilisés pour former les interconnecteurs qui relient électriquement les cellules photovoltaïques du module, et d'autre part le CTE du ou des polymères du module photovoltaïque peut entraîner une sévère localisation de contraintes thermiques dans les parties métalliques des modules. Cela entraîne des dégradations affectant grandement les performances des modules.

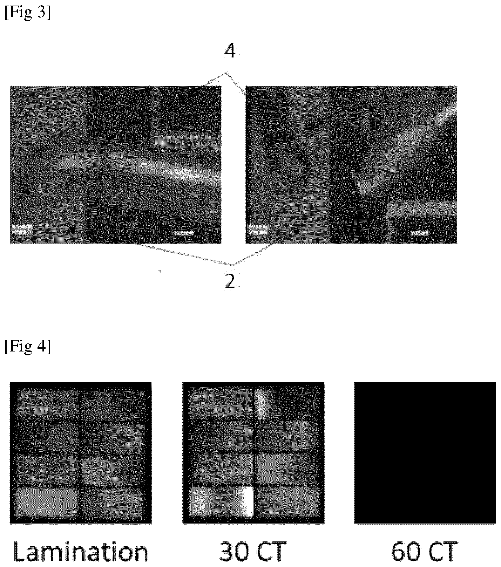

Un problème récurrent observé en cyclage thermique est la rupture des interconnecteurs 4 qui relient les cellules photovoltaïques, ce qui entraîne de fait une extinction, *i.e.* une inaptitude à la production électrique, du module photovoltaïque. La figure 3 présente des photographies acquises en microscopie optique illustrant des ruptures d'interconnecteurs 2. Un exemple d'extinction après 60 cycles de déformation thermique d'un module photovoltaïque comportant 8 unités de cellules photovoltaïques est présenté sur la figure 4, à cause des ruptures d'interconnecteurs illustrées sur la figure 3.

Pour éviter la survenance de ces dégradations, il a déjà été testé de diminuer l'épaisseur de la structure d'encapsulation polymère, mais cela peut conduire à une inaptitude du module photovoltaïque à passer avec succès les tests de certifications réglementaires, notamment les tests d'impact et de résistance à la flexion. Il a par ailleurs été envisagé de renforcer la structure d'encapsulation polymère avec des fibres ou des tissus afin de rendre le module plus rigide et plus résistant au cyclage thermique. Cependant, cela implique de modifier de manière conséquente les procédés de mise en oeuvre, ce qui complique et ralentit le développement industriel de ces modules composites. En outre, la présence de fibres modifie les propriétés optiques et dégrade le rendement énergétique du module photovoltaïque.

Il existe donc un besoin pour améliorer la résistance au cyclage thermique des modules photovoltaïques comportant une structure d'encapsulation à base polymère.

### Résumé de l'invention

L'invention propose un module photovoltaïque comportant :
- une unité photovoltaïque comportant plusieurs cellules photovoltaïques reliées électriquement en série et distantes les unes des autres, les cellules photovoltaïques adjacentes étant reliées électriquement deux à deux par un interconnecteur métallique qui s'étend au moins en partie dans un espace d'interconnexion séparant lesdites cellules photovoltaïques adjacentes,
- une structure d'encapsulation, à base d'au moins un matériau d'encapsulation polymère, prenant en sandwich les faces opposées des cellules photovoltaïques, définissant une zone de recouvrement cellulaire, et l'interconnecteur dans l'espace d'interconnexion, définissant une zone de recouvrement d'interconnecteur,
une cale incorporée dans la structure d'encapsulation et partiellement superposée à l'interconnecteur dans la zone de recouvrement d'interconnecteur, la cale étant constituée par un matériau présentant, au moins à une température de -40 °C, un module d'élasticité inférieur au module d'élasticité du matériau d'encapsulation.

Lors d'une variation de température représentative d'un cycle thermique auquel le module PV peut être soumis en usage, par exemple tel que défini dans la norme IEC61215, la cale se déforme plus facilement que l'interconnecteur pour accommoder les déformations d'origine thermique de la structure d'encapsulation. Cela permet ainsi de limiter la concentration de contraintes dans l'interconnecteur, et réduit le risque de rupture et l'extinction du module PV.

De préférence, le matériau de la cale présente un module d'élasticité plus de 2 fois, de préférence plus de 5 fois, voire plus de 10 fois inférieur au module d'élasticité du matériau d'encapsulation à une température de - 40 °C.

De préférence, le matériau de la cale présente un module d'élasticité inférieur au module d'élasticité du matériau d'encapsulation à une température de 20 °C, de préférence à toute température comprise entre -40 °C et 20 °C.

Le module d'élasticité est mesuré selon la norme NF EN ISO 527-1.

Le matériau de la cale peut présenter un module d'élasticité, mesuré à -40 °C, inférieur à 1 GPa. De préférence, le matériau de la cale présente un module d'élasticité, mesuré à -40 °C, compris entre 0,1 MPa et 300 MPa, de préférence compris entre 1 MPa et 10 MPa.

De préférence, le matériau de la cale présente un coefficient d'expansion thermique mesuré à -40°C compris entre 10⁻⁷ K⁻¹ et 10⁻⁴ K⁻¹.

De préférence, le rapport entre le CTE du matériau de la cale et le CTE du matériau d'encapsulation est compris entre 0,1 et 1, les CTE étant mesurés à -40°C.

Le coefficient d'expansion thermique est mesuré selon la norme internationale ISO 11359-2.

Le matériau de la cale peut être composite ou polymère.

De préférence, le matériau de la cale est un élastomère, notamment choisi parmi les élastomères siliconés, les caoutchoucs, les élastomères fluorés, les thermoplastiques élastomères et leurs mélanges. Par exemple, le matériau de la cale est un silicone translucide à base alcoxy.

De préférence, la cale présente une épaisseur comprise entre 100 µm et 1500 µm.

De préférence, elle présente une largeur comprise entre 100 µm et 1500 µm.

De préférence, le rapport de largeur de la cale sur la largeur de l'espace d'interconnexion est compris entre 0,1 et 0,5.

La largeur de la cale et la largeur de l'espace d'interconnexion sont mesurées perpendiculairement aux faces en regard des cellules PV adjacentes. La largeur de l'espace d'interconnexion est par exemple comprise entre 0,2 et 10 mm.

La cale peut présenter une forme d'un ruban, notamment de section rectangulaire ou carrée.

La cale peut s'étendre de part en part sur toute la longueur de l'espace d'interconnexion entre les cellules photovoltaïques adjacentes, ladite longueur étant mesurée parallèlement aux faces latérales en regard desdites cellules adjacentes.

La cale peut être non superposée à la zone de recouvrement cellulaire.

De préférence, la cale est intégralement superposée à l'espace d'interconnexion

La cale peut être contenue entre les plans dans lesquels s'étendent les faces opposées des cellules photovoltaïques.

De préférence, la cale est entièrement incorporée dans la masse de la structure d'encapsulation. Notamment, la ou toutes les faces extérieures de la cale sont en contact avec la structure d'encapsulation.

La distance entre la cale et l'interconnecteur est inférieure ou égale à 1 mm, ladite distance étant mesurée perpendiculairement au plan médian dans lequel s'étend le module PV.

Selon une variante, au moins une partie de la cale peut être en contact avec l'interconnecteur.

Le module PV peut comporter plusieurs cales recouvrant au moins partiellement l'interconnecteur dans la zone de recouvrement d'interconnecteur.

En particulier, dans l'épaisseur du module PV, au moins deux des cales sont disposées de part et d'autre de l'interconnecteur. Autrement dit, au moins une des cales est disposée entre une première face du module PV et l'interconnecteur et une autre des cales est disposée entre l'interconnecteur et une deuxième face du module PV opposée à la première face. Cela permet aux cales de mieux accommoder les déformations thermiques de la structure d'encapsulation.

La structure d'encapsulation est de préférence autoporteuse. Une structure autoporteuse est suffisamment rigide pour ne pas se déformer substantiellement sous l'effet de son propre poids.

La structure d'encapsulation prend en sandwich les cellules photovoltaïques et l'interconnecteur. De préférence, elle recouvre intégralement les cellules photovoltaïques et l'interconnecteur. De préférence, elle est en contact sur toute la superficie des cellules photovoltaïques et sur toute la superficie de l'interconnecteur.

Le matériau d'encapsulation est à base polymère, *i.e.* il comporte pour plus de 70 % de sa masse, de préférence pour plus de 80 % de sa masse, de préférence pour plus de 90 % de sa masse, de préférence pour plus de 95 % de sa masse, de préférence pour 100 % de sa masse, un matériau polymère. Le matériau polymère est adapté à une application photovoltaïque, *i.e.* il présente une transmittance adaptée à ce qu'un rayonnement solaire incident soit transmis pour activer la production électrique des cellules photovoltaïques.

De préférence, le matériau polymère est transparent au rayonnement solaire.

Le matériau d'encapsulation peut présenter un module d'élasticité compris entre 10 MPa et 10 GPa, à une température de -40 °C. Il peut présenter un module de Young compris entre 0,001 GPa et 1 GPa, à une température de 20 °C.

De préférence, le matériau polymère est thermoplastique. Il peut présenter une température de transition vitreuse supérieure à -150 °C.

De préférence, le matériau polymère est choisi parmi l'éthylène-acétate de vinyle, un copolymère éthylène-méthyl acrylate, le polytéréphtalate d'éthylène basse densité, le polyamide 11, le polycarbonate, le polytéréphtalate d'éthylène-glycol, le poly méthacrylate de méthyle, le polypropylène, le copolymère de polypropylène, l'homopolymère de polypropylène, le polytétrafluoroéthylène, le copolymère styrène-acrylonitrile, le polyuréthane thermoplastique, l'acrylonitrile butadiène styrène, le polyéthylène et leurs mélanges.

La structure d'encapsulation peut être homogène, c'est-à-dire qu'elle consiste en le matériau d'encapsulation dont la composition est identique en toute zone de la structure d'encapsulation. Comme cela sera décrit par la suite, une structure d'encapsulation homogène peut résulter du thermoformage d'une couche inférieure et d'une couche supérieure faite toutes deux du matériau polymère homogène.

En variante, la structure d'encapsulation est multicouche, au moins deux couches de la structure d'encapsulation étant en des matériaux d'encapsulation différents De préférence, la structure d'encapsulation multicouche comporte une ou plusieurs couches intérieures qui recouvrent entièrement et sont en contact avec les cellules photovoltaïques et l'interconnecteur, et des couches inférieure et supérieure qui prennent en sandwich les couches intérieures, la ou les couches intérieures et les couches inférieure et supérieure étant en des matériaux d'encapsulation différents. Les couches inférieure et supérieure peuvent être en un même matériau d'encapsulation, et peuvent en outre comporter des fibres de renforcement, par exemple des fibres de verre.

De préférence, à une température de -40 °C, et de préférence à une température de 20 °C, le module d'élasticité du matériau d'encapsulation constitutif de la ou des couches intérieures est plus faible que le module d'élasticité du matériau d'encapsulation constitutif de la couche inférieure et/ou de la couche supérieure. Les couches inférieure et supérieure apportent ainsi au module photovoltaïque de la rigidité en flexion et une résistance aux chocs, et la ou les couches intérieures permettent une meilleure distribution des contraintes d'origine thermique dans le module photovoltaïque.

De préférence, l'épaisseur du module photovoltaïque est constante dans la zone de recouvrement cellulaire.

De préférence, l'épaisseur du module photovoltaïque est constante, hormis dans la zone de recouvrement d'interconnecteur.

De préférence, l'épaisseur du module photovoltaïque est comprise entre 0,75 mm et 10 mm.

L'interconnecteur peut être en un métal choisi parmi le cuivre, l'argent, l'étain, le plomb et leurs alliages.

L'interconnecteur relie deux cellules adjacentes de l'unité photovoltaïque. De préférence, il est fixé, par exemple soudé ou collé avec un adhésif électriquement conducteur sur chacune des cellules adjacentes. De préférence, il est fixé sur une face inférieure d'une des cellules photovoltaïques adjacentes et sur une face supérieure de l'autre cellule photovoltaïque adjacente, afin de relier les pôles positifs et négatifs des cellules photovoltaïques de manière à faire circuler le courant photoélectrique.

De préférence, l'interconnecteur s'étend dans l'épaisseur du module photovoltaïque entre les cellules adjacentes qu'il relie électriquement.

L'interconnecteur peut présenter une épaisseur comprise entre 50 µm et 500 µm et/ou une largeur comprise entre 200 µm et 2000 µm.

De préférence, le module photovoltaïque s'étend selon une surface médiane qui peut être plane ou courbe.

Les cellules photovoltaïques s'étendent de préférence selon la surface médiane.

L'unité photovoltaïque peut comporter plus de deux cellules photovoltaïques, notamment au moins trois, voire au moins cinq, voire au moins dix cellules photovoltaïques.

Au sein de l'unité photovoltaïque, les cellules photovoltaïques peuvent être identiques. De préférence, elles sont alignées selon un axe d'alignement dans la surface médiane, l'espace d'interconnexion entre deux cellules photovoltaïques adjacentes s'étendant perpendiculairement à l'axe d'alignement. Leurs faces latérales peuvent être parallèles, notamment alignées selon l'axe d'alignement.

Dans la variante où l'unité photovoltaïque comporte plus de deux cellules photovoltaïques, l'interconnecteur peut connecter deux à deux électriquement en série les cellules photovoltaïques adjacentes. En particulier, il peut présenter une portion au contact d'une face d'une cellule photovoltaïque, qui s'étend d'un bord à un autre bord opposé de la cellule photovoltaïque, et qui est prolongé d'un côté par une portion s'étendant dans l'espace d'interconnexion qui relie la cellule photovoltaïque à une des cellules adjacentes.

Les cellules photovoltaïques peuvent comporter, voire consister en, du silicium. Elles peuvent être de type tandem pérovskite/silicium.

Chaque cellule photovoltaïque présente de préférence une forme d'une plaque, par exemple rectangulaire ou carrée. Au moins une des cellules photovoltaïques, notamment chaque cellule photovoltaïque peut présenter une épaisseur comprise entre 0,05 mm et 0,3 mm.

Le module photovoltaïque peut comporter plusieurs unités photovoltaïques, qui peuvent être disposées les unes par rapport aux autres à la manière d'un pavage le long de la surface médiane, par exemple selon l'axe d'alignement ou selon deux axes perpendiculaires.

L'invention concerne aussi un procédé de fabrication d'un module photovoltaïque selon l'invention, le procédé comportant :
- la fourniture d'un empilement multicouche comportant une unité photovoltaïque comportant des cellules photovoltaïques reliées électriquement en série et distantes les unes des autres, les cellules photovoltaïques adjacentes étant reliées électriquement deux à deux par un interconnecteur qui s'étend au moins en partie dans un espace d'interconnexion séparant lesdites cellules photovoltaïques adjacentes, une cale superposée au moins partiellement à l'interconnecteur dans la zone d'interconnexion, et au moins deux couches d'encapsulation qui prennent en sandwich l'unité photovoltaïque et
- le thermoformage de l'empilement multicouche jusqu'à obtention du module photovoltaïque.

Le thermoformage peut être effectué par thermocompression ou lamination.

De préférence, le thermoformage est effectué par lamination de l'empilement multicouche entre un plateau de lamination inférieur chauffé et une membrane sur laquelle est appliquée une pression de fluide.

Le procédé peut comporter une étape préalable de formation de l'empilement multicouche, ladite étape comportant la mise en place d'une cale entre l'interconnecteur et au moins une couche d'encapsulation faite du matériau d'encapsulation. Par ailleurs, l'invention concerne aussi un dispositif choisi parmi un bâtiment, un véhicule automobile, un train, un avion et un bâtiment, le dispositif intégrant sur une surface extérieure le module photovoltaïque selon l'invention. La surface extérieure peut être courbée. La surface extérieure du dispositif est par exemple un capot ou un toit d'une voiture, un mur ou un toit d'un bâtiment.

Selon un autre mode de réalisation, la cale peut-être en contact direct avec l'interconnecteur sur au moins une partie de l'espace d'interconnexion, mieux sur l'intégralité de l'espace d'interconnexion. La cale peut dépasser de l'espace d'interconnexion. Le dépassement de la cale de l'espace d'interconnexion peut être millimétrique.

En variante, la cale peut s'étendre au moins partiellement de part et d'autre de l'interconnecteur. De préférence, la cale peut enrober l'interconnecteur. Dans cette variante, les cales peuvent être constituées de gels de silicones, de liquide non aqueux avec une viscosité importante, par exemple les huiles de silicones.

### Brève description des dessins

[Fig. 1] et [Fig. 2] sont des photographies de modules photovoltaïques de l'art antérieur,
[Fig. 3] est une photographie en microscopie optique d'un interconnecteur rompu d'un module photovoltaïque de l'art antérieur,
[Fig. 4] sont des images acquises en électroluminescence de modules photovoltaïques, de gauche à droite, selon l'art antérieur après lamination, 30 cycles, et 60 cycles thermiques,
[Fig 5] représente schématiquement une vue de dessus, de face et de côté d'un exemple de module photovoltaïque selon l'invention,
[Fig 6] est une vue schématique, en coupe du module photovoltaïque au niveau d'une zone de recouvrement d'interconnecteur,
[Fig. 7] illustre schématiquement un exemple de procédé de fabrication par lamination du module photovoltaïque selon l'invention,
[Fig. 8] est une vue d'un maillage aux éléments finis d'une partie d'un module selon l'invention tel qu'illustré sur la figure 6, au niveau de la zone de recouvrement d'interconnecteur,
[Fig. 9] sont des images de la distribution des contraintes de von Mises dans un maillage de référence et dans le maillage de la figure 6 après une simulation numérique thermomécanique d'un cycle thermique,
[Fig. 10] est un graphique illustrant l'évolution de la contrainte au sens de von Mises le long du trajet illustré sur la figure 6,
[Fig. 11] est un graphique illustrant, pour différents maillages, l'évolution de la contrainte maximale dans l'interconnecteur en fonction du module d'élasticité du matériau de la cale et la réduction, exprimée en pourcents de ladite contrainte par rapport au maillage de référence sans cale,
[Fig. 12] est un graphique illustrant, pour différents maillages, l'évolution de la contrainte maximale dans l'interconnecteur en fonction de la largeur de la cale et la réduction, exprimée en pourcents de ladite contrainte par rapport au maillage de référence sans cale, et
[Fig. 13] est un graphique illustrant, pour différents maillages, l'évolution de la contrainte maximale dans l'interconnecteur en fonction de l'épaisseur de la cale et la réduction, exprimée en pourcents de ladite contrainte par rapport au maillage de référence sans cale.

### Description détaillée

Les figures 1 à 4 ont été décrites précédemment.

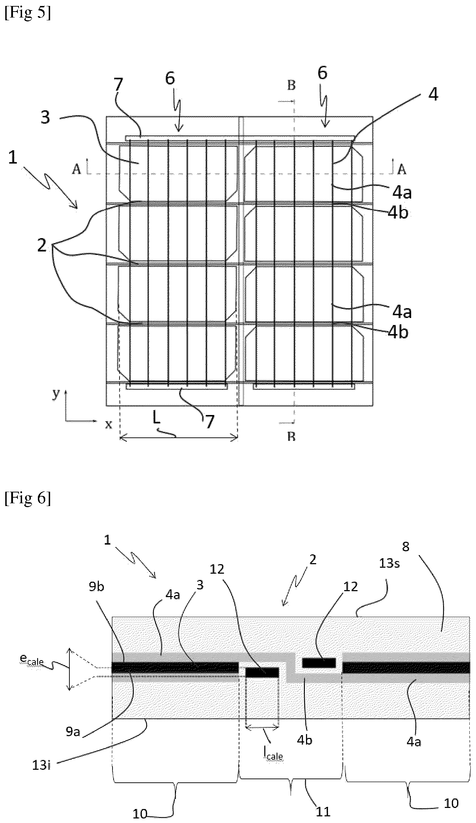

On a illustré à la figure 5 un exemple de module photovoltaïque 1 selon l'invention. Le module photovoltaïque comporte deux unités photovoltaïques 6 comportant chacune quatre cellules photovoltaïques 3, sous forme de plaquettes, qui sont distantes les unes des autres.

Chaque cellule photovoltaïque est séparée de la cellule photovoltaïque qui lui est adjacente par un espace d'interconnexion 2.

Le nombre d'unités photovoltaïques 6 et de cellules photovoltaïques 3 n'est pas limitatif et d'autres dispositions peuvent être envisagées.

Le module photovoltaïque comporte en outre des borniers de connexion 7, sous la forme de bandeaux métalliques, entres lesquels les unités photovoltaïques sont disposées en parallèle et sont électriquement reliés, afin de collecter le courant généré.

Au sein de chaque unité photovoltaïque 6, les cellules photovoltaïques 3 adjacentes sont reliées deux à deux en série par des interconnecteurs métalliques 4, par exemple en cuivre, qui s'étendent selon la direction y, de part en part entre les borniers électriques 7.

Chaque interconnecteur métallique 4 comporte des portions 4a au contact d'une face d'une cellule photovoltaïque qui sont reliées entre elles par des portions 4b qui chacune s'étendent dans l'espace d'interconnexion ménagé entre les cellules photovoltaïques 3. L'interconnecteur métallique 4 est consécutivement au contact d'une face d'une cellule photovoltaïque puis d'une face opposée de la cellule photovoltaïque adjacente. Ainsi, lorsqu'observé selon le plan en coupe (x,z) illustré sur la figure 6, l'interconnecteur serpente d'un bornier de connexion à l'autre, entre les cellules photovoltaïques 3.

Le module photovoltaïque comporte en outre une structure d'encapsulation 8 à base d'au moins un matériau polymère au sein de laquelle les unités photovoltaïques 6 sont intégralement immergées.

La structure d'encapsulation 8 recouvre intégralement les faces 9a,9b opposées des cellules photovoltaïques 3, définissant ainsi avec chaque cellule photovoltaïque 3 une zone de recouvrement cellulaire 10.

Par ailleurs, la structure d'encapsulation 8 recouvre les interconnecteurs dans les différents espaces d'interconnexion 2 entre les cellules photovoltaïques adjacentes, définissant ainsi avec l'interconnecteur 4 une zone de recouvrement d'interconnecteur 11. Dans l'exemple illustré sur la figure 6, des cales 12 sont incorporées en masse dans la structure d'encapsulation 8. Elles sont disposées de part et d'autre de l'interconnecteur dans chaque espace d'interconnexion 2 entre les faces inférieure 13i et supérieure 13s de ladite structure d'incorporation 8 et l'interconnecteur 4.

Au sein de chaque espace d'interconnexion 2, les cales 12peuvent s'étendre de part en part sur toute la longueur des faces en regard des cellules photovoltaïques adjacentes, et parallèlement auxdites faces. Elles peuvent être en outre superposées l'une sur l'autre ou être décalées l'une par rapport à l'autre selon l'axe y, comme illustré sur la figure 6.

Les cales sont par ailleurs superposées à l'interconnecteur 4 dans chaque espace d'interconnexion 2, au niveau de la zone de recouvrement d'interconnecteur, comme cela peut être observé sur vue en coupe selon un plan (y,z) sur la figure 6.

Les cales sont par exemple un ruban élastomère dont le module d'élasticité est compris entre 0,1 MPa et 300 MPa.

Afin de fabriquer le module photovoltaïque illustré sur la figure 5, un empilement multicouche 20 peut être préparé de la manière suivante. Les unités photovoltaïques 6, les bandeaux de connexion 7 et les cales 12 sont disposés entre des feuilles inférieure 21i et supérieure 21s faites d'un matériau polymère mou, de faible module d'élasticité, par exemple compris entre 10 MPa et 10 GPa à -40 °C. Les feuilles 21i,s recouvrent ainsi entièrement les unités photovoltaïques 6, les bandeaux de connexion 7 et les cales 12. L'ensemble ainsi formé peut être disposé, optionnellement, entre des feuilles externes inférieure 22i et supérieure 22s faites d'un autre matériau polymère rigide, de module d'élasticité élevé, par exemple compris entre 1 GPa et 100 GPa à -40 °C pour former l'empilement multicouche 20. Après lamination entre un plateau de lamination inférieur 24i et une membrane 25, on obtient ainsi un module photovoltaïque 1 ayant une structure d'encapsulation multicouche présentant une couche d'encapsulation interne souple dans laquelle sont immergées les unités photovoltaïques, prise optionnellement en sandwich entre des couches d'encapsulation externes rigides inférieure et supérieure.

La lamination de l'empilement multicouche 20 est réalisée classiquement en chauffant l'empilement multicouche à une température adaptée à un écoulement des matériaux polymères et sous une pression appliquée sur la membrane 25 afin de thermosceller les différents feuilles 21i,s, optionnellement 22i,s et les unités photovoltaïques 6 entre elles, puis en refroidissant jusqu'à obtention du module photovoltaïque.

L'effet de la cale dans l'espace d'interconnexion est illustré ci-après.

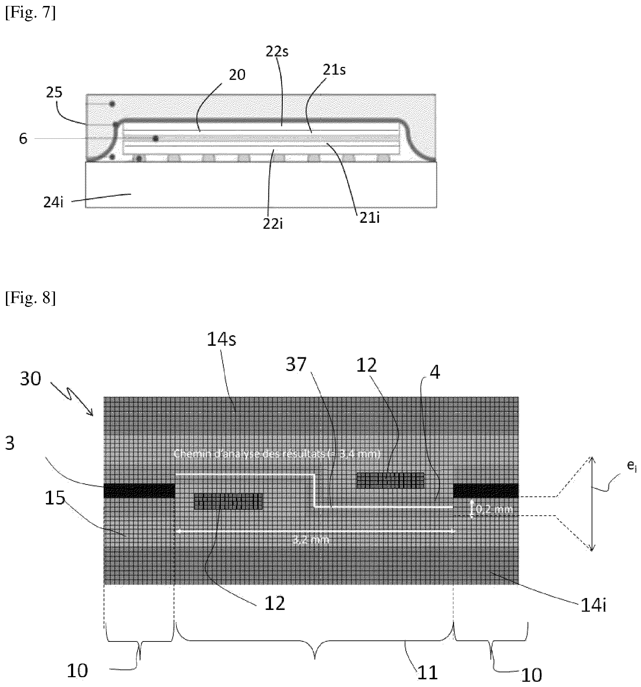

Un maillage 30 aux éléments finis 2D d'une portion du module photovoltaïque incluant l'espace d'interconnexion 2 a été réalisé, comme illustré sur la figure 8. Des éléments finis quadrangle ont été choisis afin que l'épaisseur eᵢ de l'interconnecteur, soit discrétisée avec au moins 4 éléments finis.

La structure d'encapsulation 8 modélisée comporte ainsi des couches inférieure et supérieure en polyamide 11, dont le module d'élasticité à -40°C est égal à 1620 MPa et le CTE est égal à 10⁻⁴ K⁻¹. L'épaisseur de chacune des couches inférieure et supérieure est de 400 µm.

La couche interne 15, d'épaisseur 1200 µm est en polyoléfine thermoplastique, dont le module d'élasticité à -40°C est de 590 MPa et le CTE est égal à 5*10⁻⁴ K⁻¹.

La cellule photovoltaïque 3, d'épaisseur égale à 150 µm, est en silicium, dont le module d'élasticité est égal à 166 GPa et le CTE est égal à 2,6*10⁻⁶ K⁻¹.

L'interconnecteur 4, d'épaisseur égale à 200 µm, est en cuivre et présente un module d'élasticité est égal à 130 GPa et un CTE est égal à 1,4*10⁻⁵ K⁻¹.

Les cales 12 ont une épaisseur e_{cale} et une largeur l_{cale} qui sont des paramètres modifiés en fonction des simulations réalisées, ainsi que le module d'élasticité du matériau de la cale.

Les simulations ont été réalisées en supposant un état de déformation planes, avec des modèles de comportement des matériaux thermoélastiques, et au moyen du logiciel de simulation ABAQUS. Un état libre de contrainte à 25°C a été considéré dans chaque élément fini, puis un refroidissement à une température de -40°C du module photovoltaïque a été calculé, cette température étant celle du cyclage thermique telle qu'établie dans la norme IEC6215.

Un maillage de référence, tel que celui illustré sur la figure 8 a été réalisé sans qu'aucune cale ne soit présente.

Un maillage comparatif a été établi, dans lequel le module d'élasticité du matériau de la cale est de 100 GPa, soit plus de 160 fois supérieur au matériau d'encapsulation de la couche 15 et au matériau d'encapsulation des couche 14i et 14s. La largeur l_{cale} était de 1 mm et l'épaisseur e_{cale} était égale à 200 µm.

Un maillage d'un module PV selon l'invention a été établi, celui-ci étant identique au maillage comparatif à ceci près que le module d'élasticité à -40 °C du matériau de la cale est de 1 MPa.

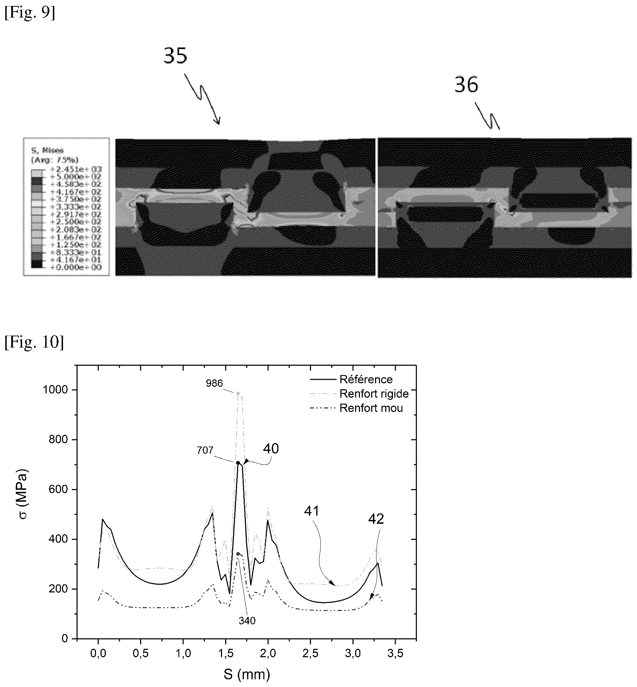

La figure 9 illustre l'effet des dilatations thermiques entre 20 °C et -40 °C qui induit des contraintes de von Mises qui sont plus élevées dans l'interconnecteur en l'absence de cale (maillage 35) . La cale moins rigide que le matériau d'encapsulation assouplit la zone de recouvrement d'interconnecteur, les contraintes de von Mises étant localement plus faibles dans l'interconnecteur (maillage 36).

Cette constatation est confirmée par la figure 10 qui représente l'évolution des contraintes de von Mises σ, exprimées en MPa, en fonction de l'abscisse S (en mm) le long du chemin 37 illustré sur la figure 8 pour le maillage de référence 35 (sans cale) (courbe 40), pour le maillage comparatif (courbe 41) et pour le maillage selon l'invention (courbe 42). La présence d'une cale présentant une rigidité trop élevée, supérieure à la rigidité des matériaux d'encapsulation renforce la concentration des contraintes dans l'interconnecteur dans la partie centrale de ce dernier. La contrainte de von Mises maximale est 39 % plus élevée que dans le maillage de référence sans cale. Au contraire, une cale plus souple que les matériaux d'encapsulation permet de limiter cette concentration de contrainte, en réduisant de 52 % la valeur maximale de la contrainte de von Mises dans l'interconnecteur.

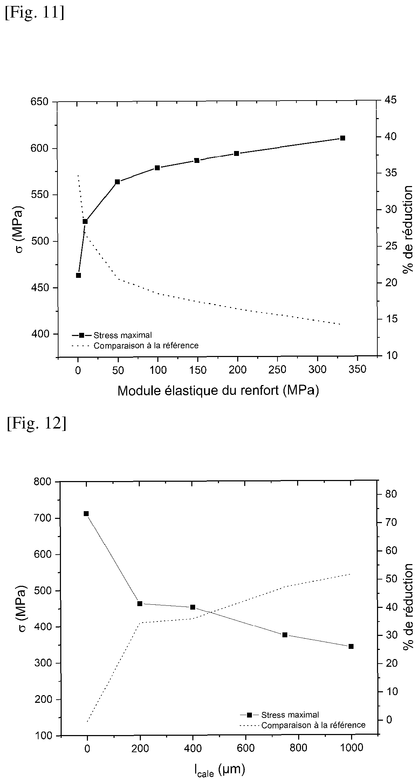

La figure 11 est un graphique indiquant la valeur maximale de la contrainte de von Mises le long du chemin 37 pour des maillages dans lesquels les cales présentent toutes une section carrée (même largeur l_{cale} de 200 µm et même épaisseur e_{cale} de 200 µm), le module d'élasticité variant de 0,1 MPa à 330 MPa. Il est observé une augmentation générale de la contrainte de von Mises avec une augmentation du module d'élasticité.

La figure 12 illustre l'évolution de la valeur maximale de la contrainte de von Mises dans l'interconnecteur, pour des maillages dans lequel le module d'élasticité à -40 °C du matériau de la cale est de 1 MPa, l'épaisseur e_{cale} est de 200 µm et la largeur l_{cale} varie de 200 µm à 1000 µm (le cas l_{cale}=0 correspond au cas de référence sans cale). Il est observé qu'une augmentation de la largeur de la cale induit une diminution jusqu'à plus de 50 % de la valeur maximale de la contrainte de von Mises dans l'interconnecteur, par rapport au cas de référence.

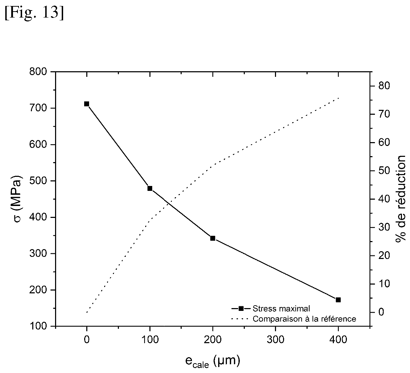

La figure 13 illustre, l'évolution de la valeur maximale de la contrainte de von Mises dans l'interconnecteur, pour des maillages dans lequel le module d'élasticité à -40 °C du matériau de la cale est de 1 MPa, la largeur l_{cale} est de 1000 µm et l'épaisseur e_{cale} varie de 100 µm à 400 µm (le cas e_{cale}=0 correspond au cas de référence sans cale). Il est observé qu'une augmentation de l'épaisseur de la cale induit une diminution jusqu'à plus de 80 % de la valeur maximale de la contrainte de von Mises dans l'interconnecteur, par rapport au cas de référence.

Comme cela apparaît à la lecture de la présente description, l'invention réduit donc les risques de rupture de l'interconnecteur en cyclage thermique.

Par « compris entre A et B », on entend de manière strictement équivalente « supérieur ou égal à A et inférieur ou égal à B ».

## Revendications

1. Module photovoltaïque (1) comportant :
- une unité photovoltaïque (6) comportant plusieurs cellules photovoltaïques (3) reliées électriquement en série et distantes les unes des autres, les cellules photovoltaïques (3) adjacentes étant reliées électriquement deux à deux par un interconnecteur métallique (4) qui s'étend au moins en partie dans un espace d'interconnexion (2) séparant lesdites cellules photovoltaïques adjacentes,
- une structure d'encapsulation (8) à base d'au moins un matériau d'encapsulation polymère, prenant en sandwich les faces opposées des cellules photovoltaïques, définissant une zone de recouvrement cellulaire (10), et l'interconnecteur (4) dans l'espace d'interconnexion (2), définissant une zone de recouvrement d'interconnecteur (11),
une cale (12) incorporée dans la structure d'encapsulation (8) et partiellement superposée à l'interconnecteur (4) dans la zone de recouvrement d'interconnecteur (11), la cale (12) étant constituée par un matériau présentant au moins, à une température de -40 °C, un module d'élasticité inférieur au module d'élasticité du matériau polymère d'encapsulation.

2. Module photovoltaïque selon la revendication 1, le matériau de la cale (12) présentant un module d'élasticité plus de 2 fois, de préférence plus de 5 fois, voire plus de 10 fois, inférieur au module d'élasticité du matériau polymère d'encapsulation à une température de -40 °C.

3. Module photovoltaïque selon l'une quelconque des revendications 1 et 2, le matériau de la cale (12) présentant un module d'élasticité inférieur au module d'élasticité du matériau d'encapsulation à une température de 20 °C, de préférence à toute température comprise entre -40 °C et 20 °C.

4. Module photovoltaïque selon l'une quelconque des revendications précédentes, le matériau de la cale (12) présentant un module d'élasticité, mesuré à -40 °C, compris entre 0,1 MPa et 300 MPa, de préférence compris entre 1 MPa et 10 MPa.

5. Module photovoltaïque selon l'une quelconque des revendications précédentes, le matériau de la cale (12) étant un élastomère, notamment choisi parmi les élastomères siliconés, les caoutchoucs, les élastomères fluorés, les thermoplastiques élastomères et leurs mélanges.

6. Module photovoltaïque selon l'une quelconque des revendications précédentes, la cale présentant une épaisseur comprise entre 100 µm et 1500 µm et/ou une largeur comprise entre 100 µm et 1500 µm.

7. Module photovoltaïque selon l'une quelconque des revendications précédentes, la cale (12) présentant une forme d'un ruban, notamment de section rectangulaire ou carrée.

8. Module photovoltaïque selon l'une quelconque des revendications précédentes, la cale (12) s'étendant de part en part sur toute la longueur de l'espace d'interconnexion entre les cellules photovoltaïques adjacentes, ladite longueur étant mesurée parallèlement aux faces latérales en regard desdites cellules adjacentes.

9. Module photovoltaïque selon l'une quelconque des revendications précédentes, le module photovoltaïque comportant plusieurs cales (12) recouvrant au moins partiellement l'interconnecteur (4) dans la zone de recouvrement d'interconnecteur (11).

10. Module photovoltaïque selon la revendication précédente, dans l'épaisseur du module PV, au moins deux des cales (12) étant disposées de part et d'autre de l'interconnecteur.

11. Module photovoltaïque selon l'une quelconque des revendications précédentes, le matériau d'encapsulation comportant pour plus de 70 % de sa masse, de préférence pour plus de 80 % de sa masse, de préférence pour plus de 90 % de sa masse, de préférence pour plus de 95 % de sa masse, de préférence pour 100 % de sa masse, un matériau polymère.

12. Module photovoltaïque selon la revendication précédente, le matériau polymère étant choisi parmi l'éthylène-acétate de vinyle, un copolymère éthylène-méthyl acrylate, le polytéréphtalate d'éthylène basse densité, le polyamide 11, le polycarbonate, le polytéréphtalate d'éthylène-glycol, le poly méthacrylate de méthyle, le polypropylène, le copolymère de polypropylène, l'homopolymère de polypropylène, le polytétrafluoroéthylène, le copolymère styrène-acrylonitrile, le polyuréthane thermoplastique, l'acrylonitrile butadiène styrène, le polyéthylène et leurs mélanges.

13. Module PV selon l'une quelconque des revendications précédentes, le matériau d'encapsulation peut présenter un module d'élasticité compris entre 10 MPa et 10 GPa, à une température de -40 °C.

14. Procédé de fabrication d'un module photovoltaïque selon l'une quelconque des revendications précédentes, le procédé comportant :
- la fourniture d'un empilement multicouche (20) comportant une unité photovoltaïque (6) comportant des cellules photovoltaïques (3) reliées électriquement en série et distantes les unes des autres, les cellules photovoltaïques adjacentes étant reliées électriquement deux à deux par un interconnecteur (4) qui s'étend au moins en partie dans un espace d'interconnexion (2) séparant lesdites cellules photovoltaïques adjacentes, une cale (12) superposée au moins partiellement à l'interconnecteur dans l'espace d'interconnexion (2), et au moins deux couches d'encapsulation (21i,21s) qui prennent en sandwich l'unité photovoltaïque et
- le thermoformage de l'empilement multicouche jusqu'à obtention du module photovoltaïque.

15. Procédé selon la revendication précédente, selon lequel le thermoformage est effectué par lamination de l'empilement multicouche entre un plateau de lamination inférieur (24i) chauffé et une membrane (25) sur laquelle est appliquée une pression de fluide.
